Europäisches Patentamt

European Patent Office

Office européen des brevets

(11) Publication number: **0 349 695**
**A1**

(12) **EUROPEAN PATENT APPLICATION**

(21) Application number: 88401786.4

(22) Date of filing: 08.07.88

(51) Int. Cl.⁴: **H01L 21/285** , **C23C 14/02** ,
**C23C 16/02**

(43) Date of publication of application:
**10.01.90 Bulletin 90/02**

(84) Designated Contracting States:
**FR**

(71) Applicant: **L'AIR LIQUIDE, SOCIETE ANONYME POUR L'ETUDE ET L'EXPLOITATION DES PROCEDES GEORGES CLAUDE**
**75, Quai d'Orsay**
**F-75321 Paris Cédex 07(FR)**

(72) Inventor: **Hirase, Ikuo**
**L'AIR LIQUIDE LABORATORIES K.K. 5-9-9**
**Tokodai**
**Toyosato-amchi Tsucuba-gun 300-26(JP)**

(74) Representative: **Vesin, Jacques et al**
**L'AIR LIQUIDE, SOCIETE ANONYME POUR L'ETUDE ET L'EXPLOITATION DES PROCEDES GEORGES CLAUDE 75, quai d'Orsay**
**F-75321 Paris Cédex 07(FR)**

(54) **Method of depositing metal on a silicon substrate.**

(57) A method of depositing a metal on a silicon substrate (11) includes the steps of performing a surface treatment of a silicon substrate (11), and depositing a metal (14, 15) on the surface of the silicon substrate (11) subjected to the surface treatment. In the surface treatment of the silicon substrate (11), the silicon substrate (11) is treated by a gas containing at least one member selected from the group consisting of $N_2F_4$, $ClF_3$, $ClF_5$, $F_2$, $Cl_2$, and $CF_4$ at a temperature of 50 to 650°C. A natural oxide on the silicon substrate surface is substantially completely removed by the surface treatment.

F I G. 2A

F I G. 2C

F I G. 2B

## METHOD OF DEPOSITING METAL ON SILICON

The present invention relates to a method of depositing a metal on silicon and, more particularly, to a surface treatment on silicon surface.

In the manufacture of semiconductor devices, a metal deposition process, especially a selective deposition process is a very important technique for forming electrodes, contacts, interconnections, and the like. As such a selective deposition process, selective deposition of a metal such as tungsten performed by low pressure chemical vapor deposition (to be referred to as LPCVD hereinafter) is recently receiving a great deal of attention.

Selective deposition of tungsten on a silicon surface by LPCVD is normally performed as follows. That is, an Si wafer covered with a patterned film such as an $SiO_2$ film is placed in a CVD chamber, and a gas mixture of $WF_6$ gas and $H_2$ gas is supplied into the chamber. Then, W is selectively deposited on the surface of the Si wafer not covered with the patterned film by reduction of $WF_6$. In this case, the deposition process is assumed to progress in the following two deposition steps.

First Deposition Step

A thin film of W is formed in accordance with the following reaction formula (1):

$$WF_6 + Si \rightarrow SiF_4 + W \quad (1)$$

That is, in the first deposition step, Si serves as a reducing agent and reduces $WF_6$, thereby performing selective deposition of W.

Second Deposition Step

A W film is formed in accordance with the following reaction formula (2):

$$WF_6 + 3H_2 \rightarrow W + 6HF \quad (2)$$

That is, in the second deposition step, $H_2$ serves as a reducing agent and reduces $WF_6$, and selective deposition of W is performed by a difference in catalytic ability between W and $SiO_2$.

Selective deposition of W performed by LPCVD described above has a serious problem, i.e., a problem of presence of a natural oxide on the Si wafer surface to be deposited. Since the natural oxide is present, the surface of the deposited W film is not smooth, and the film thickness becomes nonuniform. The reason for this is as follows.

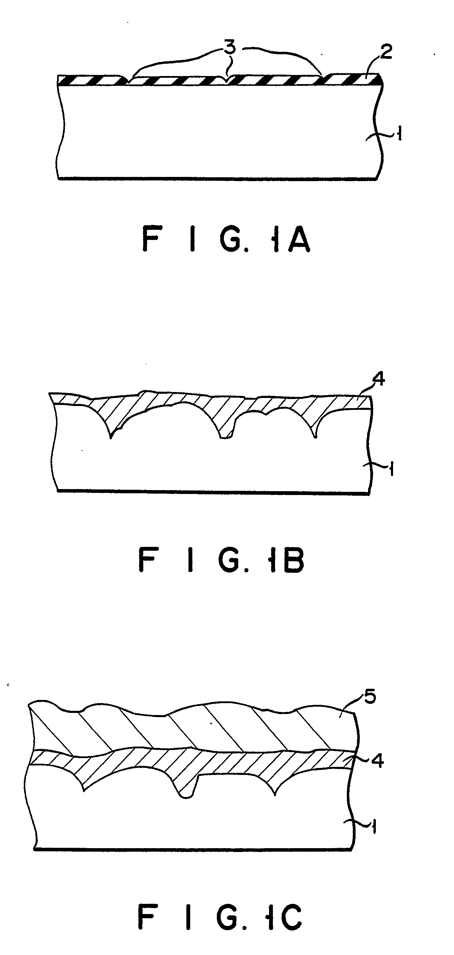

As shown in Fig. 1A, when thin and nonuniform natural oxide film 2 is present on the surface of Si wafer 1, a reaction according to the reaction formula (1) first progresses in weakest sites 3 of film 2 where $WF_6$ can penetrate. As a result, as shown in Fig. 1B, nonuniform W thin film 4 is formed. Then, when a reaction according to the reaction formula (2) progresses, W film 5 having an uneven surface, i.e., having a nonuniform thickness is formed as shown in Fig. 1C.

When such a metal film with an uneven surface and a nonuniform thickness is used to form electrodes, contact, interconnections, and the like, those having good characteristics cannot be obtained. In addition, when another interconnection layer is formed on the metal film, disconnections may occur. Furthermore, the natural oxide film present on the Si wafer surface increases a contact resistance.

In order to remove the undesired natural oxide film on the Si wafer surface, wet etching is performed using fluoric acid or the like. However, wet etching is time-consuming and troublesome because washing and drying steps must be performed after an etching step. In addition, even after removal of a natural oxide film by wet etching, another natural oxide film is formed immediately upon exposure to air.

It is, therefore, an object of the present invention to provide a method of removing a natural oxide on a silicon surface and depositing a metal having a smooth surface and a uniform film thickness.

According to the present invention, there is provided a method of depositing a metal on a silicon substrate, comprising the steps of: performing a surface treatment of a silicon substrate; and depositing a metal on the surface of the silicon substrate subjected to the surface treatment, wherein in the surface treatment of the silicon substrate, the silicon substrate is treated by a gas containing at least one member selected from the group consisting of $N_2F_4$, $ClF_3$, $ClF_5$, $F_2$, $Cl_2$, and $CF_4$ at a temperature of 50 to 650 °C.

A gas used in the treatment may contain an inert gas such as helium or argon as a carrier gas.

Examples of the metal to be deposited on the silicon substrate are molybdenum, tungsten, molybdenum silicide, tungsten silicide, titanium, titanium nitride, titanium tungsten, aluminum, copper, and polycrystalline silicon.

Examples of the method of depositing the metal are vapor evaporation, chemical vapor deposition (CVD), plasma CVD, ion plating, and sputtering.

Deposition of the metal on the silicon substrate can be selectively performed using a patterned film or performed on the entire surface not using the patterned film.

Deposition of the metal on the silicon substrate can be selectively performed using a patterned film or performed on the entire surface not using the patterned film.

In the present invention, the temperature of the surface treatment is 50 to 650° C, and preferably, 50 to 400° C. If the temperature is less than 50° C, a time required for the treatment becomes too long. If the temperature exceeds 650° C, other semiconductor elements formed on the wafer are adversely affected.

In the present invention, although the surface treatment time depends on the type of a gas and a temperature condition, it is preferably 10 seconds to 3 minutes.

In the present invention, the pressure of an atmosphere in the surface treatment is preferably $10^{-3}$ to 100 Torr.

According to the method of the present invention, the surface of a silicon substrate is treated by a predetermined gas prior to deposition of a metal. Therefore, a natural oxide on the silicon substrate surface can be completely removed at a comparatively low temperature in a short period of time. As a result, by subsequently depositing a metal, a metal film having a smooth surface and a uniform thickness can be formed.

The present invention can be understood more clearly by the following detailed description taken in conjunction with the accompanying drawings, in which:

Figs. 1A to 1C are sectional views showing conventional steps of depositing a metal on a silicon wafer; and

Figs. 2A to 2C are sectional views showing steps of depositing a metal on a silicon wafer according to a method of the present inventon.

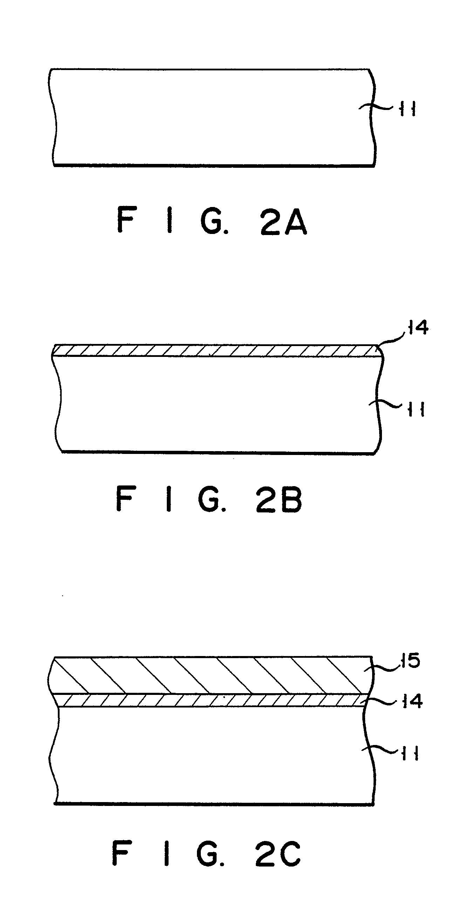

In the method of the present invention, when a silicon substrate is subjected to a surface treatment using a predetermined gas at a predetermined temperature, a natural oxide film on the surface of silicon substrate 11 is completely removed as shown in Fig. 2A. Therefore, when a gas mixture of WF₆ gas and H₂ gas is subsequently supplied, a reaction according to the reaction formula (1) described above uniformly progresses, and uniform W thin film 14 is formed as shown in Fig. 2B. Then, when a reaction according to the reaction formula (2) progresses, W film 15 having a smooth surface and a uniform thickness is formed as shown in Fig. 2C.

## Example

Tungsten was deposited on a silicon wafer surface using a single wafer cold wall LPCVD reactor.

First, a silicon wafer (diameter: 4 inch) was placed on a hot plate disposed in a reaction chamber, and the inferior of the reaction chamber was evacuated by a turbo molecular pump to obtain a pressure of $10^{-8}$ Torr. Note that a vacuum system in this apparatus comprises a rotary pump and a mechanical booster pump and can change the pressure in the reaction chamber within the range of $10^{-3}$ to 100 Torr. The pressure in the reaction chamber can be monitored by a capacitor manometer. The hot plate disposed at a central portion of the reaction chamber has a halogen lamp heater and therefore can rapidly and uniformly stabilize a temperature distribution on the wafer surface. The temperature of the wafer can be measured and controlled by an IR thermometer.

Then, $ClF_5$ gas was supplied into the reaction chamber at a flow rate of 30 SCCM (standard cubic centimeter per minute) to treat the wafer surface. Treatment conditions were such that the pressure in the reaction chamber was 0.3 Torr, the treatment temperature was 200° C, and the treatment time was 30 seconds.

After the surface treatment, a gas mixture of WF₆ gas and H₂ gas (WF₆: 10 SCCM, H₂: 200 SCCM) was subsequently supplied to form a W film having a thickness of 6000 Å on the wafer surface. Deposition conditions were such that the pressure in the reaction chamber was 0.5 Torr and the treatment temperature was 500° C.

The surface of the W film had no undulations and was very smooth. When a state of an interface between the silicon wafer and the W film was measured by an SEM, almost no natural oxide was present, and the thickness of the W film was very uniform.

## Claims

1. A method of depositing a metal on a silicon substrate (11), comprising the steps of:
performing a surface treatment of a silicon substrate (11); and
depositing a metal (14, 15) on the surface of said silicon substrate (11) subjected to the surface treatment,
characterized in that in the surface treatment of said silicon substrate (11), said silicon substrate (11) is treated by a gas containing at least one member selected from the group consisting of $N_2F_4$, $ClF_3$, $ClF_5$, $F_2$, $Cl_2$, and $CF_4$ at a temperature of 50 to 650° C.

2. A method according to claim 1, characterized in that the metal to be deposited on said silicon substrate (11) is selected from the group consisting of molybdenum, tungsten, molybdenum silicide, tungsten silicide, titanium, titanium nitride, titanium tungsten, aluminum, copper, and polycrystalline silicon.

3. A method according to claim 1, characterized in that the step of depositing the metal (14, 15) is selected from the group consisting of vapor evaporation, chemical vapor deposition, ion plating, and sputtering.

4. A method according to claim 1, characterized in that deposition of the metal (14, 15) is selectively performed on said silicon substrate (11) having a patterned film thereon.

5. A method according to claim 1, characterized in that deposition of the metal is performed on the entire surface of said substrate (11).

6. A method according to claim 1, characterized in that a temperature of the surface treatment is 50 to 400°C.

7. A method according to claim 1, characterized in that a time of the surface treatment is 10 seconds to 3 minutes.

8. A method according to claim 1, characterized in that a pressure of an atmosphere of the surface treatment is $10^{-3}$ to 100 Torr.

F I G. 1A

F I G. 1B

F I G. 1C

11

F I G. 2A

14

11

F I G. 2B

15

14

11

F I G. 2C

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | US-A-4 585 517  (STEMPLE) <br> * Claims 1-5 * | 1 | H 01 L   21/285 <br> C 23 C   14/02 <br> C 23 C   16/02 |
| A | | 2,3,5 | |
| X | THIN SOLID FILMS, vol. 126, no. 3/4, April 1985, pages 213-218, Elsevier Sequoia , Lausanne, CH; J.L. VOSSEN: "In situ low damage techniques for cleaning silicon surfaces prior to metal deposition" <br> * Page 215, line 36 - page 217, line 30 * | 1 | |
| A | Idem | 2,3,5,8 | |
| X | SOLID STATE TECHNOLOGY, vol. 28, no. 12, December 1985, pages 51-59, Port Washington, New York, US; E.K. BROADBENT et al.: "Selective tungsten processing by low pressure CVD" <br> * Page 55, line 27 - page 56, column 2, line 3 *. | 1 | |
| A | Idem | 2-4 | TECHNICAL FIELDS SEARCHED (Int. Cl.4) <br><br> H 01 L <br> C 23 C |
| A | US-A-4 605 479  (FAITH Jr.) <br> * Claims 1-3,8,9 * | 1-3,5,7 | |
| A | EP-A-0 070 751  (FAIRCHILD CAMERA AND INSTRUMENT CO.) <br> * Claim 1 * | 1-3,5 | |

The present search report has been drawn up for all claims

| Place of search | Date of completion of the search | Examiner |
|---|---|---|
| THE HAGUE | 08-12-1988 | PHEASANT N.J. |